# EUROPEAN PATENT SPECIFICATION

(11) **EP 2 295 386 B1**
(45) Date of publication and mention of the grant of the patent: **13.03.2013**
(21) Application number: 10186992.3
(22) Date of filing: 19.03.2004
(51) Int. Cl.: C03C 17/09, C03C 17/34, C03C 17/36

(54) **Glass texturing**
TEXTURIERUNG VON GLAS
TEXTURATION DU VERRE

(30) Priority: 07.04.2003 AU 2003901559
(43) Date of publication of application: 16.03.2011
(62) Divisional of application: 04721778.1
(73) Proprietor: NewSouth Innovations Pty Limited, Sydney, NSW 2052 (AU)
(72) Inventor: Aberle, Armin Gerhard, Botany, New South Wales 2019 (AU); Widenborg, Per Ingemar, Clovelly, New South Wales 2031 (AU); Chuangsuwanich, Natapol, Kensington, New South Wales 2033 (AU)
(74) Representative: Smee, Anthony James Michael

(56) References cited:
- WO-A1-00/28602
- US-A- 3 951 633
- WIDENBORG P I ET AL: "Thick poly-Si films fabricated by the aluminium-induced crystallization bi-layer process on glass substrates", CONFERENCE RECORD OF THE 29TH IEEE PHOTOVOLTAIC SPECIALISTS CONFERENCE 20020519; 20020519 - 20020524 NEW YORK, NY : IEEE, US, vol. CONF. 29, 19 May 2002 (2002-05-19), pages 1206-1209, XP010666498, ISBN: 978-0-7803-7471-3
- WIDENBORG P ET AL: "Back electrode formation for poly-Si thin film solar cells on glass having AIC-grown seeding layer", SOLAR ENERGY MATERIALS AND SOLAR CELLS, ELSEVIER SCIENCE PUBLISHERS, AMSTERDAM, NL, vol. 74, no. 1-4, 1 October 2002 (2002-10-01), pages 305-314, XP004376956, ISSN: 0927-0248
- WIDENBORG P I ET AL: "Surface morphology of poly-Si films made by aluminium-induced crystallisation on glass substrates", JOURNAL OF CRYSTAL GROWTH, ELSEVIER, AMSTERDAM, NL, vol. 242, no. 3-4, 1 July 2002 (2002-07-01), pages 270-282, XP004368857, ISSN: 0022-0248

## Description

### Technical field

The present invention relates broadly to a method of texturing a glass surface, to a method of manufacturing a photovoltaic device, to a textured glass surface, and to a photovoltaic device.

### Background

Textured glass surfaces are useful for a number of applications, including in photovoltaic devices or for applications in which it is desired to scatter light rays such that objects are no longer clearly visible through the glass.

In photovoltaic devices, light trapping is used to trap light in the active region of the device. The more light is trapped in the device the higher the light-generated photocurrent, and consequently the higher the energy conversion efficiency of the device. Therefore, light trapping is an important issue when trying to improve the conversion efficiency of photovoltaic devices and is particularly important in thin-film devices. Because most photovoltaic devices involve a glass pane, light trapping in these devices can be realised by texturing the glass pane.

Conventionally, chemical texturing or sand blasting are used for texturing glass panes. Alternative approaches have recently been disclosed for preparing textured glass surfaces. One of those approaches uses metal crystal deposits on a glass surface to form very fine crystals and thereby producing the glass texture effect. Another approach uses a liquid surface coating ("sol-gel") containing SiO₂ spheres that, after densification, produces a textured glass surface.

However, these methods have specific disadvantages for photovoltaic device applications. Both chemical texturing and sand blasting can cause cracks and non-uniform feature size on the glass surface, which can adversely affect photovoltaic device fabrication and/or performance (for instance by causing electrical shunts in the devices). On the other hand, the use of fine metal crystals for making a textured glass surface appears to be quite an expensive method. Finally, it appears to be difficult to scale up the sol-gel method to very large dimensions (∼ 1 m²) as required for photovoltaic panels.

A need, therefore, exists to provide an alternative method of texturing a glass surface which addresses one or more of these disadvantages.

WO00/28602 discloses a method of texturing a glass surface using a chemical etch.

### Disclosure of the invention

In accordance with a first aspect of the present invention there is provided a method of texturing a glass surface, the method comprising the steps of coating the glass surface with an aluminium film, stimulating a reaction at the interface between the glass and the material film resulting in the formation of reaction products at the interface such that an interfacial surface on un-reacted glass at the interface is textured, and removing the aluminiumfilm and the reaction products from the glass surface by a chemical etch.

In one embodiment, the step of stimulating the reaction at the interface comprises a thermal annealing process. The thermal annealing process may comprise a sequence of annealing steps at different temperatures. The thermal annealing process may be conducted in a controlled ambient atmosphere.

The material film may comprise a single material or compound material. The glass surface may initially be substantially flat.

The reaction products may comprise aluminium oxide.

The step of removing the material film and the reaction products may comprise one or more etching steps. The etching steps comprise a chemical etch.

The glass may comprise quartz, float glass, or non-float glass.

In accordance with a second aspect of the present invention there is provided a method of manufacturing a photovoltaic device, the method comprises the steps of texturing a glass surface utilising the method as defined in the first aspect, and depositing a semiconductor film on the textured glass surface, whereby the glass-facing surface of the semiconductor film exhibits substantially the same degree of texture as the glass surface.

In one embodiment, the semiconductor film is deposited in a manner such that substantially no gaps or voids exist between the textured glass surface and the semiconductor film.

The method may further comprise forming a dielectric barrier layer between the glass surface and the semiconductor. The dielectric layer may be formed on the textured glass surface prior to the deposition of the semiconductor film. The dielectric barrier layer may comprise silicon oxide or silicon nitride.

The semiconductor film may comprise a crystalline and/or an amorphous semiconductor material. The semiconductor material may comprise silicon.

In accordance with a third aspect of the present invention there is provided a textured glass pane formed utilising the method as defined in the first aspect.

In accordance with a fourth aspect of the present invention there is provided a photovoltaic device manufactured utilising the method as defined in the second aspect.

In accordance with a fifth aspect of the present invention there is provided a photovoltaic device comprising a glass pane having a textured surface according to the third aspect, a semiconductor film formed on the textured surface of the glass pane and having an internal absorption efficiency greater than about 0.5 for photons in a wavelength range from about 600 to 1200 nm.

### Brief description of the drawings

Preferred embodiments of the invention will now be described, by way of example, with reference to the accompanying drawings in which:
Figures 1 to 4 are schematic drawings illustrating a method of texturing the surface of a glass pane, embodying the present invention.
Figure 5 shows a FIB (focused ion beam) microscopical photograph of the top surface of a silicon-coated textured glass pane, embodying the present invention.
Figure 6 shows a FIB microscopical photograph of a different region of the sample of Figure 5.
Figure 7 shows the measured light trapping properties of the sample of Figure 5, compared with prior art samples.

### Detailed description and best mode

The embodiments described provide methods of texturing a glass surface suitable for use in the manufacturing of thin-film semiconductor photovoltaic devices.

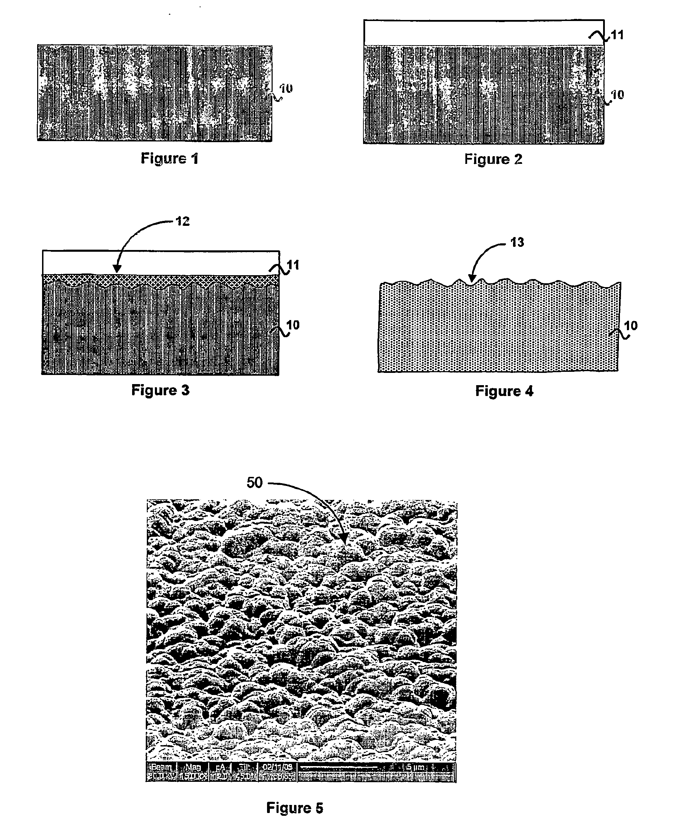

Figures 1 to 4 are schematic drawings illustrating a method of texturing the surface of a glass pane 10, embodying the present invention. Figure 1 shows the glass pane 10, having a substantially flat upper surface and being a borosilicate glass in an example embodiment.

In a first step shown in Figure 2, the glass pane 10 is coated with an aluminium film 11 utilising, in the example embodiment, thermal vacuum evaporation at about 10⁻⁵ Torr. In the example embodiment, the initial aluminium coating 11 is of a thickness of about 500 nm.

Next, the Al-coated glass pane is thermally annealed at elevated temperature, in the example embodiment in a two-step process with about 120 mins at about 500°C, followed by about 360 mins at about 620°C in a nitrogen atmosphere.

In another embodiment, a three-step process with about 120 mins at about 500°C, followed by about 180 mins at about 560°C, followed by about 180 mins at about 630°C in a nitrogen atmosphere may be applied.

It has been found by the applicants that the Al reacts spatially non-uniformly with the glass pane, forming reaction products in the form of mixtures (12 in Figure 3) of aluminium oxide and silicon. A subsequent removal of both the Al film 11 and the reaction products 12 forms a textured glass surface as schematically shown in Figure 4. In the example embodiment, a 2-step chemical etch with about 10 mins in 85% phosphoric acid solution at about 110°C, followed by about 20 to about 45 secs in a 1:1HF/HNO₃ solution at room temperature was used to remove the reaction products 12 and aluminium film 11.

In another embodiment, a 2-step chemical etch with about 10 mins in phosphoric acid at about 110°C, followed by a second etch in a HF/HNO₃ solution at room temperature where the HF/HNO₃ is in the range from about 1:1 to 1:20 is applied. Depending on the ratio used, a short ultrasonic waterbath treatment may be utilised after the second etching step to completely remove all reaction products.

It is noted here, that, depending on the type of removal technique, for example the type of etching solution, used, some amount of glass that has not reacted with the coating can also be removed, if desired.

Dimples (13 in Figure 4) in the glass pane result from the removal of the Al/glass reaction products 12. The average size of the dimples can be adjusted over a wide range (from less than 1 µm to up to 10 µm) by e.g. selecting a suitable thermal annealing profile and/or a suitable removal technique for the Al/glass reaction products 12. This dimple size is well suited for thin-film photovoltaic applications because in those devices the semiconductor film thickness is typically in the range 0.5 - 3 µm.

In the example embodiment, the method textures the glass in such a way that there are no "overhanging" regions, i.e. when the textured glass pane 10 of Fig. 4 was illuminated by parallel light from above, there were no shaded regions within the dimples of the surface texture. This feature is advantageous for device applications, for instance if the subsequently formed semiconductor film needs to be in intimate contact with the glass everywhere (i.e., there must be no voids or gaps between the glass and the semiconductor film).

Another advantageous feature of textured glass samples embodying the present invention is that their transmission for light is only very weakly reduced by the texture.

Figure 5 shows a FIB microscopical photograph of the top surface 50 of a silicon-coated textured glass pane fabricated using a method embodying the present invention. The silicon film is of polycrystalline nature and has a thickness of about 1.5 µm (i.e., similar to the dimensions of the texture features). It was created by thermal annealing ("'solid-phase crystallisation") of a plasma enhanced chemical vapour deposition (PECVD)-deposited amorphous silicon film. The striking feature of the surface 50 of the silicon coated glass pane is its cauliflower-like nature, caused by the textured glass surface [note that the silicon film has a planar, smooth top surface if fabricated on a non-textured (i.e., planar) glass pane]. The cauliflower-like top surface 50 of the silicon film is an indicator for good light trapping characteristics.

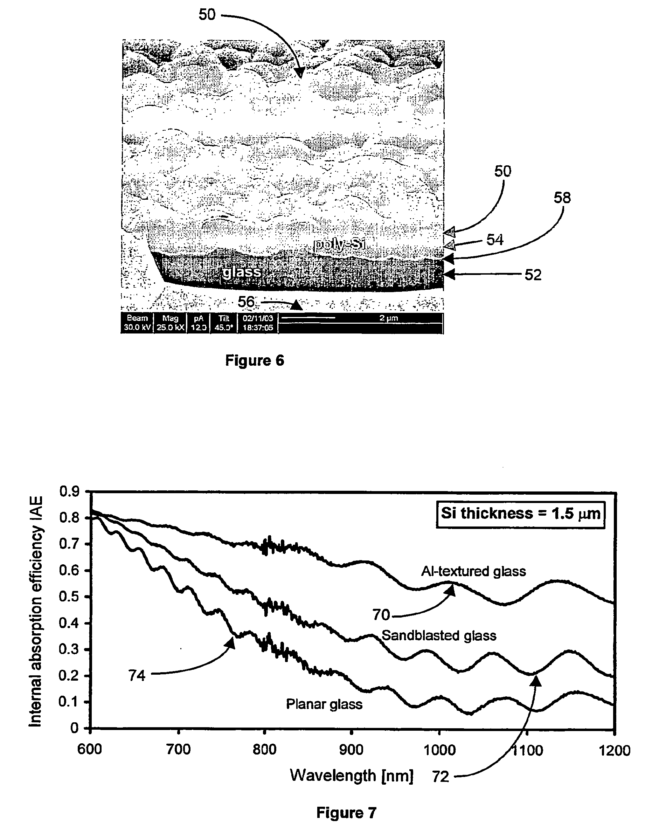

Figure 6 shows a FIB microscopical photograph of a different region of the same sample, whereby additionally a trench was milled (using gallium ions) into the sample surface to reveal the cross-sectional properties of both the textured glass pane 52 and the polycrystalline silicon film 54 subsequently formed on the surface of the textured glass pane 52. The lateral marker 56 in Fig. 6 represents 2 µm. It can be seen that the poly-Si film 54 is everywhere in intimate contact with the surface of the textured glass pane 52 and that there are no voids or gaps between the glass pane 52 and the poly-Si film 54. This is advantageous for many device applications due to issues such as adhesion of the semiconductor film to the glass, long-term stability of the device, etc..

Another feature visible in Figure 6, advantageous for good light trapping in thin-film photovoltaic devices, is the fact that in most regions of the sample the "top" and "bottom" surfaces 50 and 58 respectively of the poly-Si film 54 are sufficiently non-parallel, leading to the trapping of light due to the phenomenon of total internal reflection. However, it is noted that even if the two surfaces 50, 58 are substantially parallel, i.e. if the texture of the glass-facing surface 58 of the poly-Si film 54 is "directly transferred", resulting in a corresponding texture on the surface 50 facing away from the glass 52, useful light trapping characteristics can still be achieved.

The light trapping can be further improved in actual devices by incorporating a back-surface reflector (BSR) (not shown) for near-infrared photons. The BSR can, for instance, be a silver or aluminium film. The BSR is either deposited onto the semiconductor film (if the sunlight enters the semiconductor through the glass) or onto the non-textured glass surface (if the semiconductor-coated, textured side of the glass faces the sun).

Figure 7 shows that excellent light trapping is realised in thin (∼1.5 micron) polycrystalline silicon films formed on glass panes textured according to the described embodiment. The curve 70 labelled "Al-textured glass" was measured on the sample of Figure 5. The plotted parameter is the measured internal absorption efficiency (IAE) which, for each wavelength, describes which fraction of those photons that entered the Si film is absorbed within the Si film. The higher the IAE the better the light trapping.

Also shown, for comparison, is the measured IAE of a 1.5-µm thick poly-Si film on a planar glass pane (curve 74) and on a sandblasted glass pane (curve 72). Clearly, the Al-textured glass provides by far the best light trapping of the three investigated structures. Note that the samples did not have a back surface reflector (BSR) during these optical measurements and hence the IAE of actual devices (such as thin-film photovoltaics) can be further improved by adding a suitable BSR.

It is further noted that glass panes textured in accordance with the described embodiment efficiently scatter light rays that pass through the glass panes, making them useful for other applications outside their use for photovoltaic devices. One such application is e.g. as glass panes for scattering windows or screens.

It will be appreciated by the person skilled in the art that numerous modifications and/or variations may be made to the present invention as shown in the specific embodiments without departing from the spirit or scope of the invention as broadly described. The present embodiments are, therefore, to be considered in all respects to be illustrative and not restrictive.

For example, it will be appreciated that the present invention is not limited to the dimensions and/or thin-film deposition techniques and/or reaction products removal techniques of the example embodiments described.

Furthermore, while in the embodiments described the glass texturing processes were optimised for borosilicate glass, it will be appreciated that the processing can be chosen and optimised for different glasses, including sodalime glass, which is often used as a cheap window glass.

## Claims

1. A method of texturing a glass surface (50), the method **characterised by** the steps of:
- coating the glass surface with an aluminium film (11);
- stimulating a reaction at the interface between the glass (50) and the aluminium film (11) resulting in the formation of reaction products (12) at the interface such that an interfacial surface of un-reacted glass at the interface is textured; and
- removing the aluminium film (11) and the reaction products (12) from the glass surface by a chemical etch.

2. The method as claimed in claim 1, wherein the step of stimulating the reaction at the interface comprises a thermal annealing process.

3. The method as claimed in claims 1 or 2, wherein the thermal annealing process comprises a sequence of annealing steps at different temperatures.

4. The method as claimed in any one of the preceding claims, wherein the thermal annealing process is conducted in a controlled ambient atmosphere.

5. The method as claimed in claim 1, wherein the aluminium film (11) comprises a single material or compound material.

6. The method as claimed in any one of the preceding claims, wherein the reaction products (12) comprise aluminium oxide and/or silicon.

7. The method as claimed in any one of the preceding claims, wherein the step of removing the aluminium film (11) and the reaction products (12) comprises one or more etching steps.

8. The method as claimed in any one of the preceding claims, wherein the glass comprises quartz, float glass, or non-float glass.

9. A method of manufacturing a photovoltaic device, the method comprises the steps of texturing a glass surface (50) utilising a method as claimed in any one of the preceding claims, and depositing a semiconductor film on the textured glass surface, whereby the glass-facing surface of the semiconductor film exhibits substantially the same degree of texture as the glass surface.

10. The method as claimed in claim 9, wherein the semiconductor film is deposited in a manner such that substantially no gaps or voids exist between the textured glass surface and the semiconductor film.

11. The method as claimed in claims 9 or 10, wherein the method further comprises forming a dielectric barrier layer between the glass and the semiconductor.

12. The method as claimed in claim 11, wherein the dielectric layer is formed on the textured glass surface (50) prior to the deposition of the semiconductor film.

13. The method as claimed in claims 11 or 12, wherein the barrier layer comprises silicon oxide or silicon nitride.

14. The method as claimed in any one of claims 10 to 14, wherein the semiconductor film comprises a crystalline and/or an amorphous semiconductor material.

15. The method as claimed in claim 14, wherein the semiconductor material comprises silicon.

16. A glass pane (11) having a textured surface (50) formed utilising a method as claimed in any one of claims 1 to 8.

17. A photovoltaic device manufactured utilising a method as claimed in any one of claims 9 to 16.

18. A photovoltaic device comprising:
a glass pane having a textured surface according to claim 16;
a semiconductor film formed on the textured surface of the glass pane and having an internal absorption efficiency greater than about 0.5 for photons in a wavelength range from about 600 to 1200 nm.

## Patentansprüche

1. Verfahren zum Texturieren einer Glasoberfläche (50), wobei das Verfahren durch folgende Schritte gekennzeichnet ist:
- Beschichten der Glasoberfläche mit einem Aluminiumfilm (11),
- Anregen einer Reaktion an der Grenzfläche zwischen dem Glas (50) und dem Aluminiumfilm (11), die in der Bildung von Reaktionsprodukten (12) an der Grenzfläche resultiert, so dass eine Grenzflächen-Oberfläche von nicht reagiertem Glas an der Grenzfläche texturiert wird; und
- Entfernen des Aluminiumfilms (11) und der Reaktionsprodukte (12) von der Glasoberfläche durch ein chemisches Ätzen;

2. Verfahren nach Anspruch 1, wobei der Schritt des Anregens der Reaktion an der Grenzfläche einen Temperprozess umfasst.

3. Verfahren nach Ansprüchen 1 oder 2, wobei der Temperprozess eine Folge von Temperschritten bei verschiedenen Temperaturen umfasst.

4. Verfahren nach einem der vorangehenden Ansprüche, wobei der Temperprozess in einer kontrollierten Umgebungsatmosphäre ausgeführt wird.

5. Verfahren nach Anspruch 1, wobei der Aluminiumfilm (11) ein einziges Material oder zusammengesetztes Material umfasst.

6. Verfahren nach einem der vorangehenden Ansprüche, wobei die Reaktionsprodukte (12) Aluminiumoxid und/oder Silizium umfassen.

7. Verfahren nach einem der vorangehenden Ansprüche, wobei der Schritt des Entfernens des Aluminiumfilms (11) und der Reaktionsprodukte (12) einen oder mehrere Ätzschritte umfasst.

8. Verfahren nach einem der vorangehenden Ansprüche, wobei das Glas Quarz, Floatglas oder Nicht-Floatglas umfasst.

9. Verfahren zum Herstellen einer Photovoltaikvorrichtung, wobei das Verfahren die Schritte des Texturierens einer Glasoberfläche (50) unter Nutzung eines Verfahrens nach einem der vorangehenden Ansprüche und das Abscheiden eines Halbleiterfilms auf der texturierten Glasoberfläche umfasst, wobei die dem Glas zugewandte Oberfläche des Halbleiterfilms im Wesentlichen den selben Grad an Textur aufweist, wie die Glasoberfläche.

10. Verfahren nach Anspruch 9, wobei der Halbleiterfilm auf eine derartige Weise abgeschieden wird, dass im Wesentlichen keine Lücken oder Hohlräume zwischen der texturierten Glasoberfläche und dem Halbleiterfilm existieren.

11. Verfahren nach Anspruch 9 oder 10, wobei das Verfahren weiter das Bilden einer dielektrischen Sperrschicht zwischen dem Glas und dem Halbleiter umfasst.

12. Verfahren nach Anspruch 11, wobei die dielektrische Schicht vor dem Abscheiden des Halbleiterfilms auf der texturierten Glasoberfläche (50) gebildet wird.

13. Verfahren nach Anspruch 11 oder 12, wobei die Sperrschicht Siliziumoxid oder Siliziumnitrid umfasst.

14. Verfahren nach einem der Ansprüche 10 bis 14, wobei der Halbleiterfilm ein kristallines und/oder ein amorphes Halbleitermaterial umfasst.

15. Verfahren nach Anspruch 14, wobei das Halbleitermaterial Silizium umfasst.

16. Glasscheibe (11) mit einer texturierten Oberfläche (50), die unter Nutzung eines Verfahrens nach einem der Ansprüche 1 bis 8 gebildet wird.

17. Photovoltaikvorrichtung, die unter Nutzung eines Verfahrens nach einem der Ansprüche 9 bis 16 hergestellt wird.

18. Photovoltaikvorrichtung, die Folgendes umfasst:
eine Glasscheibe mit einer texturierten Oberfläche nach Anspruch 16;
einen Halbleiterfilm, der auf der texturierten Oberfläche der Glasscheibe gebildet ist und eine innere Absorptionseffizienz von größer als ungefähr 0,5 für Photonen in einem Wellenlängenbereich von ungefähr 600 bis 1200 nm aufweist.

## Revendications

1. Procédé de texturation d'une surface en verre (50), le procédé étant **caractérisé par** les étapes de :
- revêtement de la surface en verre avec un film d'aluminium (11) ;
- stimulation d'une réaction à l'interface entre le verre (50) et le film d'aluminium (11), résultant en la formation de produits de réaction (12) à l'interface de sorte à ce qu'une surface interfaciale du verre qui n'a pas réagi à l'interface soit texturée ; et
- retrait du film d'aluminium (11) et des produits de réaction (12) de la surface en verre par une attaque chimique.

2. Procédé selon la revendication 1, dans lequel l'étape de stimulation de la réaction à l'interface comprend un procédé de recuit thermique.

3. Procédé selon les revendications 1 ou 2, dans lequel le procédé de recuit thermique comprend une séquence d'étapes de recuit à différentes températures.

4. Procédé selon l'une quelconque des revendications précédentes, dans lequel le procédé de recuit thermique est effectué dans une atmosphère ambiante contrôlée.

5. Procédé selon la revendication 1, dans lequel le film d'aluminium (11) renferme un matériau unique ou un matériau composé.

6. Procédé selon l'une quelconque des revendications précédentes, dans lequel les produits de réaction (12) renferment de l'oxyde d'aluminium et/ou du silicium.

7. Procédé selon l'une quelconque des revendications précédentes, dans lequel l'étape de retrait du film d'aluminium (11) et des produits de réaction (12) comprend une ou plusieurs étapes d'attaque.

8. Procédé selon l'une quelconque des revendications précédentes, dans lequel le verre renferme du quartz, du verre flotté ou du verre non flotté.

9. Procédé de fabrication d'un dispositif photovoltaïque, le procédé comprenant les étapes de texturation d'une surface en verre (50) en utilisant un procédé selon l'une quelconque des revendications précédentes et en déposant un film semiconducteur sur la surface en verre structuré, si bien que la surface de parement en verre du film semiconducteur présente essentiellement le même degré de texture que la surface en verre.

10. Procédé selon la revendication 9, dans lequel le film semiconducteur est déposé d'une manière telle qu'il n'existe essentiellement aucun espace ou vide entre la surface en verre texturé et le film semiconducteur.

11. Procédé selon les revendications 9 ou 10, dans lequel le procédé comprend en outre la formation d'une couche barrière diélectrique entre le verre et le semiconducteur.

12. Procédé selon la revendication 11, dans lequel la couche diélectrique est formée sur la surface en verre texturé (50) avant le dépôt du film semiconducteur.

13. Procédé selon les revendications 11 ou 12, dans lequel la couche barrière renferme de l'oxyde de silicium ou du nitrure de silicium.

14. Procédé selon l'une quelconque des revendications 10 à 14, dans lequel le film semiconducteur renferme un matériau semiconducteur cristallin et/ou amorphe.

15. Procédé selon la revendication 14, dans lequel le matériau semiconducteur renferme du silicium.

16. Vitre (11) ayant une surface texturée (50) formée en utilisant un procédé tel que celui revendiqué dans l'une quelconque des revendications 1 à 8.

17. Dispositif photovoltaïque fabriqué en utilisant un procédé tel que celui revendiqué dans l'une quelconque des revendications 9 à 16.

18. Dispositif photovoltaïque comprenant :
une vitre ayant une surface texturée selon la revendication 16 ;
un film semiconducteur formé sur la surface texturée de la vitre et ayant une efficacité d'absorption interne supérieure à environ 0,5 pour les photons compris dans une plage de longueurs d'ondes de 600 à 1200 nm.
